# EUROPÄISCHE PATENTSCHRIFT

(11) **EP 0 335 160 B1**
(45) Veröffentlichungstag und Bekanntmachung des Hinweises auf die Patenterteilung: **03.11.1993**
(21) Anmeldenummer: 89104419.0
(22) Anmeldetag: 13.03.1989
(51) Int. Cl.: H01R 23/70, H01R 9/09

(54) **Steckverbinder mit abgewinkelten Kontaktpfosten zum Einpressen in Leiterplattenbohrungen**
Plug connector with angular contact pins to be pushed into the holes of a printed circuit
Connecteur avec pieds de contact pliés à angle droit destiné à être monté par pression dans les trous d'un circuit imprimé

(30) Priorität: 26.03.1988 DE 3810471
(43) Veröffentlichungstag der Anmeldung: 04.10.1989
(73) Patentinhaber: HARTING ELEKTRONIK GmbH, 32325 Espelkamp (DE)
(72) Erfinder: Harting, Dietmar, D-4992 Espelkamp (DE); Nagel, Hans, Dipl.-Ing., D-4952 Porta Westfalica (DE); Pape, Günter, Dipl.-Ing., D-4800 Bielefeld (DE)

(56) Entgegenhaltungen:
- EP-A- 0 128 306
- US-A- 4 050 769
- US-A- 4 469 387

## Beschreibung

Die Erfindung betrifft einen Steckverbinder mit abgewinkelten Kontaktpfosten zum Einpressen in Leiterplattenbohrungen, mit einem Kontaktelemente beinhaltenden Isolierkörper, der einerseits zur Aufnahme eines entsprechend ausgebildeten Gegensteckers ausgebildet ist und aus dessen rückwärtiger Anschlußseite als stiftförmige Kontaktpfosten ausgebildete Verlängerungen der Kontaktelemente herausragen, wobei die Kontaktpfosten rechtwinklig zur Steckrichtung des Gegensteckers abgebogen sind, und wobei die Kontaktpfosten mit einem Einpreßabschnitt zur kontaktierenden Befestigung in Leiterplattenbohrungen ausgebildet sind.

Beim Einpressen derartiger Steckverbinder in Leiterplatten ist es erforderlich, die Einpreßkraft auf die Oberseite der Kontaktpfosten-Abwinklungen aufzubringen und zwar möglichst in genau axialer Richtung des mit dem Einpreßabschnitt versehenen Kontaktpfostens.

Problematisch ist das Einpressen derartiger Steckverbinder insbesondere dann, wenn die Steckverbinder mit mehreren parallelen Kontaktreihen, wie z.B. bei Steckverbindern nach DIN 41 612, versehen sind, wobei hier die abgewinkelten Kontaktpfosten der verschiedenen Kontaktreihen beim Austritt aus dem Steckverbinder-Isolierkörper, in Einpreßrichtung gesehen, übereinander angeordnet sind.

Ein Steckverbinder der eingangs genannten Art ist aus der DE-OS 33 18 135 bekannt. Zum Einpressen dieses Steckverbinders ist ein mit Schlitzen bzw. Taschen versehenes Einpreßwerkzeug vorgesehen, welches die abgewinkelten Kontaktpfosten aufnimmt, und mit dessen Hilfe der Einpreßvorgang durchgeführt wird. Dabei sind jedoch zur Aufnahme der Pfosten und zum eigentlichen Einpreßvorgang zwei um 90° verschiedene Bewegungsrichtungen des Werkzeuges beim Einpressen sowie bei der anschließenden Entfernung des Werkzeuges nötig.

Der Erfindung liegt nunmehr die Aufgabe zugrunde, einen Steckverbinder der eingangsgenannten Art dahingehend auszubilden, daß zum Einpressen der Kontaktpfosten des Steckverbinders in Leiterplattenbohrungen ein möglichst einfaches Hilfswerkzeug verwendet werden kann und wobei beim Einpreßvorgang nur eine einzige Bewegungsrichtung des Werkzeugs erforderlich ist.
Diese Aufgabe wird erfindungsgemäß dadurch gelöst,
daß ein kammartiges, mit Schlitzen zur Aufnahme und seitlichen Führung der Anschlußpfosten versehenes, aus Isoliermaterial geformtes Zusatzteil von der Leiterplatten-Anschlußseite her zwischen die Kontaktpfosten geschoben ist,
daß in den Schlitzen des Zusatzteiles Auflageschultern aufweisende Querstege vorgesehen sind, auf denen die senkrecht aus dem Isolierkörper herausragenden Bereiche der Kontaktpfosten nach dem Einschieben des Zusatzteiles aufliegen, und
daß die Querstege in ihrer Höhe so bemessen sind, daß ihre Unterseite auf der Oberseite der unter den Querstegen befindlichen Kontaktpfosten aufliegt.
Weitere vorteilhafte Ausgestaltungen der Erfindung sind in den Ansprüchen 2 bis 5 angegeben.

Die mit der Erfindung erzielten Vorteile bestehen insbesondere darin, daß zum Einpressen des Steckverbinders lediglich ein einfaches Einpreßwerkzeug verwendet werden kann, wobei hierbei auch nur eine einzige Bewegungsrichtung des Werkzeuges erforderlich ist.

Ein weiterer Vorteil ist darin zu sehen, daß der Isolierkörper des Steckverbinders selbst, in gleicher Ausführung wie bei den bekannten Ausführungen nach DIN 41 612 zum Einlöten in Leiterplatten ausgebildet sein kann, so daß hier im Hinblick auf wirtschaftliche Fertigung größere Mengen gefertigt werden können und durch ein preiswertes Zusatzteil die Möglichkeit geschaffen wird derartige abgewinkelte Steckverbinder auch für die Einpreßtechnik vorzusehen. Insbesondere wenn ein weiteres Stützteil in das Zusatzteil eingefügt wird, wird ein Ausweichen/Knicken der Kontaktpfosten beim Einpreßvorgang verhindert, so daß auch bei unsachgemäßer Handhabung - wie z.B. stoßartigem Aufbringen der Einpreßkraft - ein sicheres Einpressen der Kontaktpfosten sichergestellt ist.

Ein Ausführungsbeispiel der Erfindung ist in der Zeichnung dargestellt und wird im folgenden näher beschrieben. Es zeigen
- Fig. 1: die Ansicht eines Steckverbinders,
- Fig. 2: die Ansicht des Steckverbinders gem. Fig. 1 in auseinandergezogener Darstellung,
- Fig. 3: die Ansicht des Steckverbinders gem. Fig. 1 im Schnitt entlang der Linie 3-3, und
- Fig. 4: die Ansicht eines Einpreßwerkzeuges.

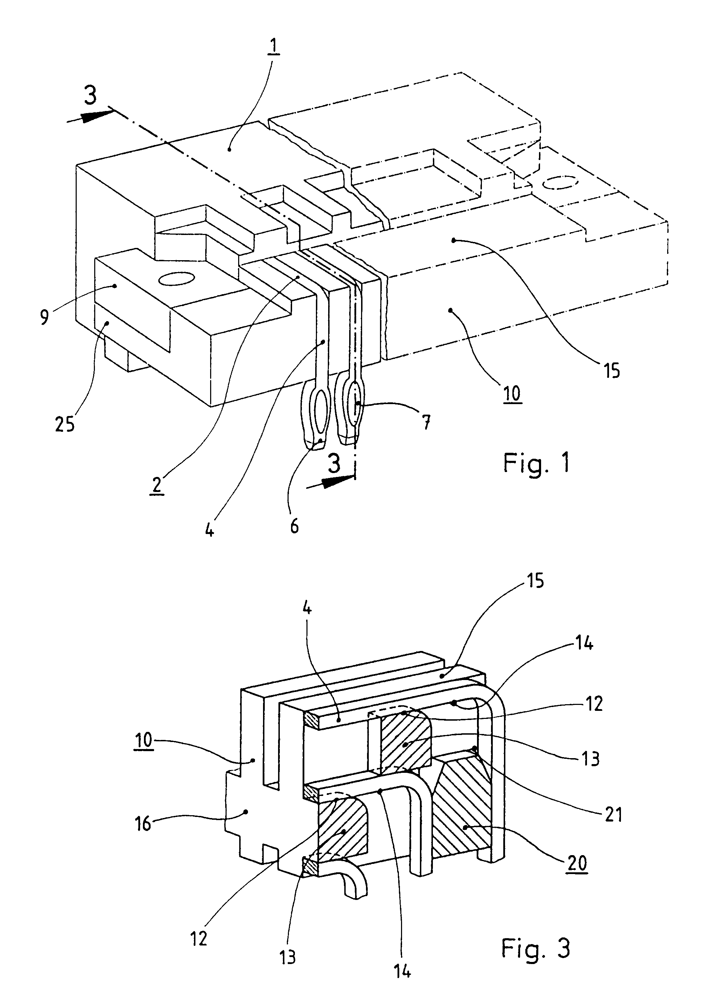

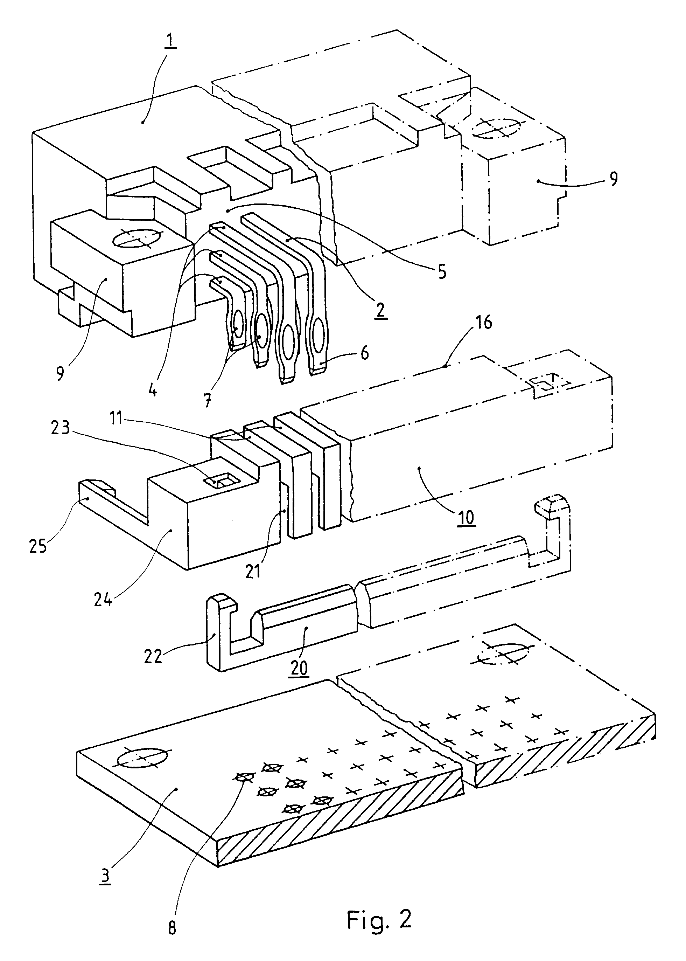

Der in den Fig. 1 und 2 dargestellte Steckverbinder besteht im wesentlichen aus einem an sich bekannten Isolierkörper 1 mit darin gehaltenen Kontaktelementen 2. Die Kontaktelemente sind in mehreren (hier z.B. drei) parallelen Reihen angeordnet und ihre zur Verbindung mit einer Leiterplatte 3 vorgesehen Kontaktpfosten 4 ragen aus der rückwärtigen Anschlußseite 5 des Isolierkörpers hervor. Die Kontaktpfosten sind rechtwinklig zur Steckrichtung des Gegensteckers - d.h. senkrecht zur Leiterplatte 3 hin - abgebogen und an ihren Enden 6 mit einem Einpreßabschnitt 7 zur Befestigung und Kontaktgabe in entsprechenden Leiterplatten-Bohrungen 8 versehen. Seitliche Flansche 9 am Isolierkörper 1 mit entsprechenden Befestigungsbohrungen sind zur zusätzlichen Befestigung des Steckverbinders an der Leiterplatte vorgesehen.

Wie in Fig. 2 erkennbar, sind die verschiedenen Reihen von Kontaktpfosten 4 jeweils direkt unter- bzw. übereinander angeordnet. Um die Kontaktpfosten mit ihren Einpreßabschnitten 7 in die Bohrungen der Leiterplatte einpressen zu können, muß auf die einzelnen Pfosten eine Einpreßkraft ausgeübt werden, und zwar auf die Oberseite der waagerecht verlaufenden Pfostenbereiche. Dabei sollte diese Kraft möglichst genau mittig zur Achse der abgewinkelten Pfostenenden aufgebracht werden, zumindest jedoch möglichst dicht/nahe an dieser Achse.
Hierzu ist ein kammförmiges, aus Isoliermaterial geformtes Zusatzteil 10 vorgesehen, welches von der Leiterplattenanschlußseite - d.h. der Richtung des Steckverbinders in die die abgewinkelten Pfosten mit den Einpreßbereichen weisen - her, zwischen die Kontaktpfosten 4 geschoben wird. Dabei ist dieses Zusatzteil mit Schlitzen 11 versehen, in denen die Kontaktpfosten 4 seitlich geführt und gehalten sind. In den Schlitzen sind Auflageschultern 12 bildende Querstege 13 ausgebildet, wobei diese Querstege in Bezug auf ihre Höhe und Breite so bemessen sind, daß sie soeben zwischen den jeweils benachbarten Kontaktpfosten der übereinanderliegenden Pfostenreihen hindurchgeschoben werden können.

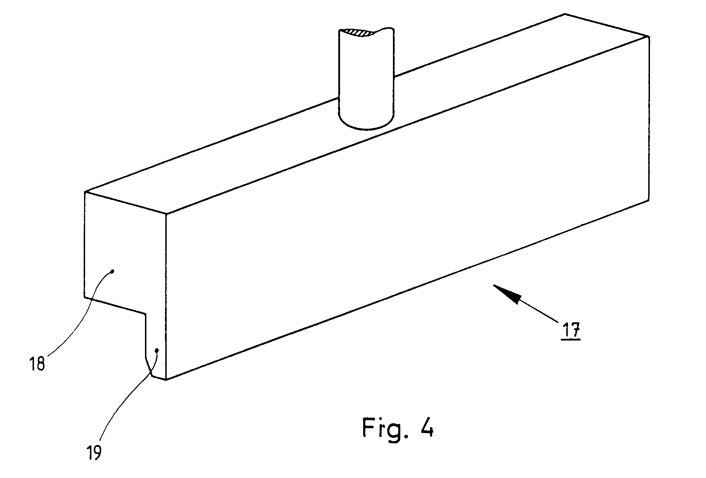

Beim Einfügen des Zusatzteiles 10 wird dieses zunächst von unten her zwischen die Kontaktpfosten geschoben, bis die Querstege an den unteren Flächen 14 der waagerecht aus dem Isolierkörper 1 herausragenden Pfosten 4 anstoßen, und die Oberseite der oberen Pfostenreihe mit der Oberseite 15 des Zusatzteiles bündig anschließt. Anschließend wird das Zusatzteil in um 90° versetzter Richtung geschoben, bis seine Vorderseite 16 an der Rückseite 5 des Isolierkörpers 1 anliegt, wobei dann die Rückseite der hinteren/äußeren Pfostenreihe bündig mit der Rückseite des Zusatzteiles anschließt. Diese Lage des Zusatzteiles bzw. der Querstege in Bezug auf die Kontaktpfosten ist in der Fig. 3 dargestellt. Wie aus der Darstellung entnehmbar sind die Querstege dabei formschlüssig zwischen den waagerechten Bereichen der Kontaktpfosten angeordnet, so daß eine auf die Oberseite 15 des Zusatzteiles bzw. Oberseite der oberen Pfostenreihe ausgeübte Kraft kraftschlüssig auf sämtliche Kontaktpfosten übertragen wird und zwar in unmittelbarer Nähe der Achsen der senkrechten Pfostenbereiche.
Zur Halterung des Zusatzteiles 10 an dem Isolierkörper 1 sind Rastmittel 25 vorgesehen, die in den Bereich der Flansche 9 des Isolierkörpers greifen, wie beispielsweise in der Fig. 2 dargestellt.

Ein mit einem derartigen Zusatzteil versehener Steckverbinder kann nun auf eine Leiterplatte 3 aufgesetzt werden, wobei die stiftförmigen Enden 6 der Pfosten in die Leiterplatten-Bohrungen 8 eintauchen, und mit Hilfe eines einfachen Einpreßwerkzeuges (Fig. 4) können die Einpreßabschnitte 7 in die Bohrungen eingepreßt werden. Dabei ist das Einpreßwerkzeug 17 als ebener, auf die Oberfläche 15 des Zusatzteiles einwirkender Stempel 18 ausgebildet, jedoch vorzugsweise mit einer um 90° abgewinkelten Stützplatte 19 versehen. Diese Stützplatte verhindert, daß die äußere Pfostenreihe beim Einpreßvorgang nach außen wegknicken/ausweichen kann.

Um auch einem eventuellen Ausbiegen/Wegknicken der mittleren Pfostenreihe beim Einpreßvorgang entgegenzuwirken, wobei sich herausgestellt hat, daß ein Ausbiegen der Pfosten um so eher auftritt, je größer der Abstand des oberen, querverlaufenden Pfostenbereiches, auf den die Einpreßkraft ausgeübt wird, von der Einpreßzone ist, so daß bei der inneren, kurzen Reihe keine Knickneigung vorhanden ist, ist ein weiteres, balkenförmiges Stützteil 20 vorgesehen. Hierzu ist das Zusatzteil 10 im unteren Bereich, und zwar zwischen der äußeren und mittleren Pfostenreihe, mit einer querverlaufenden Ausnehmung 21 versehen, in die das Stützteil formschlüssig eingefügt werden kann. Die Breite des Stützteiles entspricht dabei genau dem Abstand dieser beiden Reihen. Seitliche Rasthaken 22 am Stützteil sind dabei in entsprechend ausgebildete Ausnehmungen 23 in den Seitenteilen 24 des Zusatzteiles einfügbar und verrastbar. Nach dem Einfügen des Stützteiles liegt dieses zwischen der äußeren und mittleren Pfostenreihe, wie in Fig. 3 dargestellt, so daß beim Einpressen des Steckverbinders die mittlere Pfostenreihe abgestützt ist und einem evtl. Ausknicken der Pfosten wirksam entgegengewirkt wird.

Bei Verwendung des Stützteiles kann die Verrastung von Zusatzteil und Isolierkörper entfallen, da nach dem Einfügen des Stützteiles die gesamte Anordnung formschlüssig zusammengehalten ist.

## Patentansprüche

1. Steckverbinder mit abgewinkelten Kontaktpfosten zum Einpressen in Leiterplattenbohrungen, mit einem Kontaktelemente beinhaltenden Isolierkörper, der einerseits zur Aufnahme eines entsprechend ausgebildeten Gegensteckers ausgebildet ist und aus dessen rückwärtiger Anschlußseite als stiftförmige Kontaktpfosten ausgebildete Verlängerungen der Kontaktelemente herausragen, wobei die Kontaktpfosten rechtwinklig zur Steckrichtung des Gegensteckers abgebogen sind, und wobei die Kontaktpfosten mit einem Einpreßabschnitt zur kontaktierenden Befestigung in Leiterplattenbohrungen ausgebildet sind, dadurch gekennzeichnet,
daß ein kammartiges, mit Schlitzen (11) zur Aufnahme und seitlichen Führung der Anschlußpfosten (4) versehenes, aus Isoliermaterial geformtes Zusatzteil (10) von der Leiterplatten-Anschlußseite her zwischen die Kontaktpfosten (4) geschoben ist, daß in den Schlitzen (11) des Zusatzteiles (10) Auflageschultern (12) aufweisende Querstege (13) vorgesehen sind, auf denen die senkrecht aus dem Isolierkörper (1) herausragenden Bereiche der Kontaktpfosten nach dem Einschieben des Zusatzteiles aufliegen, und
daß die Querstege (13) in ihrer Höhe so bemessen sind, daß ihre Unterseite auf der Oberseite der unter den Querstegen befindlichen Kontaktpfosten aufliegt.

2. Steckverbinde nach Anspruch 1, dadurch gekennzeichnet,
daß das Zusatzteil (10) mit Rasteinrichtungen (25) versehen ist, die nach dem vollständigen Einschieben zwischen die Anschlußpfosten an dem Steckverbinder-Isolierkörper (1) in Eingriff gelangen.

3. Steckverbinder nach Anspruch 1 oder 2, dadurch gekennzeichnet,
daß im zur Leiterplatte (3) weisenden Bereich des Zusatzteiles (10) eine quer verlaufende Ausnehmung (21) vorgesehen ist, in die ein weiteres, balkenförmiges Isolierteil/Stützteil (20) einfügbar ist, wobei dieses Stützteil paßgenau zwischen hintereinander liegende Anschlußpfosten (4) eingefügt und mit dem ersten Zusatzteil (10) mittels Rasteinrichtungen (22) verbunden ist.

4. Steckverbinder nach einem oder mehreren der vorhergehenden Ansprüche, dadurch gekennzeichnet,
daß nach dem Einfügen des Zusatzteiles (10) die Oberseiten der oberen Kontaktpfosten-Reihe bündig mit der Oberseite (15) des Zusatzteiles abschließen.

5. Steckverbinder nach einem oder mehreren der hervorgehenden Ansprüche, dadurch gekennzeichnet,
daß nach dem Einfügen des Zusatzteiles (10) die hintere/äußere Kontaktpfostenreihe bündig mit der Rückseite des Zusatzteiles abschließt.

## Claims

1. Plug-type connector with angled contact posts for press-insertion into circuit-board holes, said connector having an insulator which contains contact elements and on one side is shaped to receive a correspondingly shaped mating connector, while extensions of the contact elements, formed as pin-shaped contact posts, protrude from its rear connection side, these contact posts being bent at right-angles to the direction in which said mating connector is plugged in and being formed with a press-insertion section for achieving electrically contacting fixing in circuit-board holes,
characterized in that a comb-like supplementary piece (10) is pushed between the contact posts (4), in the direction away from the connection side of the circuit board, this supplementary piece (10) being moulded in an insulating material and being provided with slots (11) for receiving the connection posts (4) and guiding them laterally,
in that transverse bridges (13) are provided inside the slots (11) of the supplementary piece (10), these transverse bridges presenting supporting shoulders (12) on which those zones of the contact posts which protrude at right-angles from the insulator (1) bear, once said supplementary piece has been pushed in, and in that the height of the transverse bridges (13) is made such that the undersurface of each bridge bears on the upper surface of the contact post beneath it.

2. Plug-type connector according to Claim 1,
characterized in that the supplementary piece (10) is provided with snap-locking devices (25) which engage once it has been completely push-inserted between the connection posts on the insulator (1) of the plug-type connector.

3. Plug-type connector according to Claim 1 or 2,
characterized in that a transverse recess (21) is provided in that zone of the supplementary piece (10) which faces the circuit board (3), and an additional, bar-shaped insulating/supporting piece (20) can be inserted into said recess (21) in a manner such that it fits precisely between connection posts (4) which are located one behind another, and is connected to the first, supplementary piece (10) by means of snap-locking devices (22).

4. Plug-type connector according to one or more of the preceding Claims, characterized in that once the supplementary piece (10) has been inserted, the upper surfaces of the upper-row contact posts are flush with its upper surface (15).

5. Plug-type connector according to one or more of the preceding Claims, characterized in that once the supplementary piece (10) has been inserted, the rear/outer-row contact posts are flush with its rear surface.

## Revendications

1. Connecteur avec pieds de contact pliés à angle droit destiné à être monté par pression dans les trous d'un circuit imprimé, comportant un corps d'isolation contenant des éléments de contact, qui d'une part est adapté pour recevoir un contre-connecteur de forme correspondante et d'où sortent, du côté de connexion arrière, des prolongements des éléments de contact formés comme pieds de contact à la manière de pointes, les pieds de contact étant pliés à angle droit dans la direction de connexion du contreconnecteur, et les pieds de contact présentant une section pour le montage par pression destinée à leur fixation et à l'établissement du contact dans les trous de circuits imprimés, caractérisé en ce qu'une pièce supplémentaire (10) à la manière d'un peigne, avec des fentes (11) pour la réception et le guidage latéral des pieds de connexion (4), formée en matériau isolant, est glissée à partir du côté de connexion du circuit imprimé entre les pieds de contact (4), que des barrettes transversales (13) présentant des épaulements d'appui (12) sont prévues dans les fentes (11) de la pièce supplémentaire (10), sur lesquelles les zones de pieds de contact sortant perpendiculairement du corps d'isolation (1) reposent après l'insertion de la pièce supplémentaire, et
que les barrettes transversales (13) sont dimensionnées en hauteur de manière à ce que leur face inférieure repose sur la face supérieure des pieds de contact se trouvant sous les barrettes transversales.

2. Connecteur selon la revendication 1, caractérisé en ce que la pièce supplémentaire (10) est pourvue de dispositifs d'encliquetage (25) qui, après l'insertion intégrale, s'engagent entre les pieds de contact dans le corps d'isolation (1) du connecteur.

3. Connecteur selon les revendications 1 ou 2, caractérisé en ce que dans la zone dirigée vers le circuit imprimé (3) de la pièce supplémentaire (10) une échancrure transversale (21) est prévue dans laquelle une pièce d'isolation/d'appui (20) supplémentaire en forme de barre peut être insérée, cette pièce d'appui étant de forme adaptée pour s'insérer parfaitement entre les pieds de contact (4) se succédant et étant reliée avec la première pièce supplémentaire (10) au moyen des dispositifs d'encliquetage (22).

4. Connecteur selon l'une ou plusieurs des revendications précédentes, caractérisé en ce qu'après l'insertion de la pièce supplémentaire (10) les faces supérieures de la rangée supérieure de pieds de contact arrivent à fleur de la face supérieure (15) de la pièce supplémentaire.

5. Connecteur selon l'une ou plusieurs des revendications précédentes, caractérisé en ce qu'après l'insertion de la pièce supplémentaire (10) la rangée de pieds de contact arrière/extérieure arrive à fleur de la face arrière de la pièce supplémentaire.
